# EUROPÄISCHE PATENTSCHRIFT

(11) **EP 0 771 422 B1**
(45) Veröffentlichungstag und Bekanntmachung des Hinweises auf die Patenterteilung: **16.12.1998**
(21) Anmeldenummer: 95925728.8
(22) Anmeldetag: 18.07.1995
(51) Int. Cl.: G01R 25/04

(54) **VERFAHREN ZUM MESSEN DES PHASENJITTERS EINES DATENSIGNALS**
PROCESS FOR MEASURING PHASE JITTER OF A DATA SIGNAL
PROCEDE DE MESURE DU BRUIT DE PHASE DE SIGNAUX DE DONNEES

(30) Priorität: 21.07.1994 DE 4426713
(43) Veröffentlichungstag der Anmeldung: 07.05.1997
(73) Patentinhaber: TEKTRONIX, INC., Wilsonville, Oregon 97070-1000 (US)
(72) Erfinder: MÄRZ, Freimut, D-85764 Oberschlei heim (DE)
(74) Vertreter: Hofstetter, Alfons J., Dr.rer.nat.
(86) Internationale Anmeldenummer: DE9500977
(87) Internationale Veröffentlichungsnummer: WO9603659

(56) Entgegenhaltungen:
- DE-A- 2 121 405
- DE-A- 3 833 486
- GB-A- 2 199 470

## Beschreibung

Die Erfindung bezieht sich auf ein Verfahren zum Messen des Phasenjitters eines Datensignals und eine Schaltungsanordnung zur Durchführung dieses Verfahrens.

Ein Verfahren zum Messen des Phasenjitters eines Datensignals ist aus der IEE-Veröffentlichung "International Conference on Measurements for Telecommunication Transmission Systems - MTTS 85, 1985, Seiten 173 und 174 bekannt. Bei diesem bekannten Verfahren wird ein vorgegebenes Taktsignal als Referenzsignal verwendet und zur Bestimmung des Phasenjitters eines Datensignals jeweils das vorgegebene Taktsignal mit dem Datensignal hinsichtlich der Phasenlage verglichen. Schwierigkeiten ergeben sich bei diesem bekannten Verfahren durch statische Phasenverschiebungen, die zu einer Verringerung des Dynamikbereichs führen. Außerdem ergeben sich bei dem bekannten Verfahren hochfrequente Komponenten in bezug auf das Basisband des gewonnenen Jittersignals, so daß ein Tiefpaßfil-ter zur Eliminierung eingesetzt werden muß.

Der Erfindung liegt die Aufgabe zugrunde, das bekannte Verfahren so auszugestalten, daß es bei vergleichsweise geringem Aufwand genaue Meßergebnisse liefert.

Zur Lösung dieser Aufgabe wird bei einem Verfahren zum Messen des Phasenjitters eines Datensignals aus einem vorgegebenen Taktsignal mit Hilfe einer Torschaltung und einer Frequenzteilung ein Takthilfssignal abgeleitet, dessen Frequenz der Frequenz des Datensignals entspricht, und es wird die Phasendifferenz zwischen dem Datensignal und dem Takthilfssignal ermittelt; bei Feststellung einer eine vorgegebene Abweichung in der Phase zwischen dem Datensignal und dem Takthilfssignal überschreitenden Abweichung wird die Torschaltung unter Gewinnung eines geänderten Takthilfssignals so gesteuert, daß die Abweichung in der Phase unter die vorgegebene Abweichung absinkt; danach wird aus dem geänderten Takthilfssignal ein Taktvergleichssignal gebildet, welches eine solche Phasenlage zu dem geänderten Takthilfssignal aufweist, daß bei einem eingangsseitig mit dem Taktvergleichssignal und dem Datensignal beaufschlagten Phasendemodulator mit einem ein rampenförmiges Signal erzeugenden Integrator und nachgeordnetem Abtast-Halte-Glied bei einem Phasenjitter Null die ansteigende Flanke des entsprechenden Impulses des Datensignals zeitlich in die Mitte des rampenförmigen Signals fällt, und anschließend werden zum Messen des Phasenjitters das Datensignal und das Taktvergleichssignal dem Phasendemodulator zugeführt, wobei mittels des Taktvergleichssignals jeweils der Integrator gestartet und das Abtast-Halte-Glied auf Abtast-Funktion geschaltet und mittels des Datensignals jeweils das Abtast-Halteglied auf Halte-Funktion umgeschaltet wird.

Es ist zwar aus Seite 31 der obengenannten Veröffentlichung bekannt, im Rahmen der Messung des Phasenjitters amplitudenmodulierte Impulse dadurch zu gewinnen, daß ein mit dem Takt gekoppeltes rampenförmiges Signal beim Auftreten eines Datensignals abgetastet wird, jedoch wird bei diesem bekannten Verfahren offensichtlich kein Phasenvergleicher verwendet, der über eine von einer Steuerschaltung gesteuerte Torschaltung und einen Frequenzteiler an ein vorgegebenes Taktsignal angeschlossen ist.

Ferner ist aus der deutschen Patentschrift DE 38 33 486 C1 ein Verfahren und eine Schaltungsanordnung zum Messen des Phasenjitters eines Datensignals bekannt, bei dem ein ein rampenförmiges Signal erzeugender Integrator mit einem nachgeordneten Abtast-Halte-Glied verwendet wird, jedoch wird bei diesem bekannten Verfahren der Integrator jeweils dann zum Erzeugen des rampenförmigen Signals freigegeben, wenn eine vorgeordnete Freigabeschaltung ein Ausgangssignal erzeugt. Dieses Ausgangssignal wird in Abhängigkeit vom Auftreten eines Taktsignals und vom Ausgangszustand eines digitalen Vergleichers erzeugt, dem eine Anordnung mit einem vom Taktsignal beaufschlagten Rastzähler und zwei Rastspeichern vorgeordnet ist; die Rastspeicher werden eingangsseitig parallel mit aus den Datensignalen abgeleiteten Impulsen beaufschlagt. An den digitalen Vergleicher ist ausgangsseitig auch ein Adressengenerator angeschlossen, dem ein Zwischenspeicher mit nachgeschaltetem Digital-Analog-Wandler nachgeordnet ist; am Ausgang des Digital-Analog-Wandlers tritt ein Grobwert für den Phasenjitter auf. Ein Feinwert für den Phasenjitter ergibt sich am Ausgang des Abtast-Halte-Gliedes. Aus diesen beiden Werten wird mittels einer Summierschaltung eine den Phasenjitter angebende Meßgröße erzeugt.

Ein wesentlicher Vorteil des erfindungsgemäßen Verfahrens besteht darin, daß bei ihm das vorgegebene Taktsignal in eine definierte Phasenbeziehung zu dem Datensignal mittels des Phasenvergleichers und der Torschaltung mit dem nachgeordneten Frequenzteiler gebracht wird.

Dazu wird bei dem erfindungsgemäßen Verfahren das geänderte Taktsignal in vorteilhafter Weise durch Unterdrücken von jeweils so vielen Impulsen des vorgegebenen Taktsignals durch entsprechende Ansteuerung der Torschaltung von der Steuereinrichtung aus gewonnen, bis die Abweichung in der Phase zwischen dem Datensignal und dem geänderten Takthilfssignal unter die vorgegebene Abweichung gesunken ist. Diese Art der Gewinnung des Takthilfssignals läßt sich besonders einfach durchführen.

Auch hinsichtlich der Gewinnung des Taktvergleichssignals wird wegen der leichten Durchführbarkeit in entsprechender Weise bei dem erfindungsgemäßen Verfahren vorgegangen, indem das Taktvergleichssignal durch Unterdrücken einer derartigen Anzahl von Impulsen des Taktsignals durch Ansteuerung der Torschaltung von der Steuereinrichtung ausgewonnen wird, daß das Taktvergleichssignal gegenüber dem geänderten Takthilfssignal um eine der halben Anstiegszeit des rampenförmigen Ausgangssignals des Integrators entsprechende Zeitdauer verschoben ist.

Das erfindungsgemäße Verfahren läßt sich in vorteilhafter Weise zum Messen des Phasenjitters von ISDN(Integrated Services Digital Network)-Datensignalen mehrstufiger Codes anwenden, wenn zum Messen des Phasenjitters von ISDN-Datensignalen mehrstufiger Codes in einer Auswerteschaltung aus den Datensignalen diejenigen Datensignale als relevante Datensignale erfaßt werden, die über den durch den jeweiligen Code vorgegebenen vollen Signalhub verlaufen, und einem Phasenvergleicher, der die Phasendifferenz zwischen dem Datensignal und dem Takthilfssignal ermiltelt, und dem Phasendemodulator entsprechende Auswerte-Signale als Datensignale zugeführt werden; von einer der Auswerteschaltung nachgeordneten, in dem Phasendemodulator enthaltenen Steuereinheit wird durch das Takthilfssignal der Integrator gestartet und das dem Integrator nachgeordnete Abtast-Halte-Glied zum Abtasten veranlaßt, und es wird von einem relevanten Datensignal angestoßen von der Steuereinheit das Abtast-Halte-Glied auf Halte-Funktion und ein nachgeschaltetes weiteres Abtast-Halte-Glied zur Übernahme des festgehaltenen Abtastwertes auf Halte-Funktion geschaltet, bevor das erste Abtast-Halte-Glied bei einem Wiederholungsstart des Integrators wieder zum Abtasten veranlaßt wird; der jeweils übernommene Abtastwert am Ausgang des weiteren Abtast-Halte-Gliedes wird als Meßwert des Phasenj itters abgenommen.

Ein wesentlicher Vorteil dieser Form des erfindungsgemäßen Verfahrens wird darin gesehen, daß mit ihm auch bei ISDN-Datensignalen mehrstufiger Codes der Phasenjitter eindeutig bestimmt werden kann, weil nur relevante Datensignale erfaßt werden; diese sind dadurch gekennzeichnet, daß sie den durch den jeweiligen Code vorgegebenen vollen Signalhub durchlaufen, während alle anderen Datensignale bei der Messung des Phasenjitters unberücksichtigt bleiben. Letzteres wiederum ist nur deshalb ohne wesentliche Meßfehler möglich, weil in vorteilhafter Weise bei dem erfindungsgemäßen Verfahren eine Steuereinheit vorgesehen ist, die auf ein vorgegebenes Taktsignal hin einen Integrator mit zwei nachgeordneten Abtast-Halte-Gliedern steuert. Durch die beiden Abtast-Halte-Glieder ist dafür gesorgt, daß beim Auftreten von nicht relevanten Datensignalen der letzte erfaßte Abtastwert des Integrators festgehalten wird, wodurch am Ausgang des weiteren Abtast-Halte-Gliedes der zuletzt gemessene Meßwert erhalten bleibt. Die dadurch erzeugte Fehlmessung ist jedoch infolge der hohen Frequenz der Datensignale unbeachtlich, so daß sich das erfindungsgemäße Verfahren zur Phasenjittermessung durch eine relativ hohe Meßgenauigkeit trotz Vorliegens von ISDN-Datensignalen mehrstufiger Codes auszeichnet.

Bei einer Schaltungsanordnung zum Durchführen der eben beschriebenen Form des erfindungsgemäßen Verfahrens kann die Auswerteschaltung in unterschiedlicher Weise ausgebildet sein, sofern sie nur sicherstellt, daß die relevanten Datensignale zuverlässig erfaßt werden. Als besonders vorteilhaft wird es jedoch angesehen, wenn gemäß einer weiteren Ausgestaltung der Erfindung die Auswerteschaltung eingangsseitig mit drei von den Datensignalen parallel beaufschlagten Komparatoren versehen ist, von denen der erste Komparator auf eine vorgegebene, unterhalb einer Schwelle Null liegende untere Schwelle, der zweite Komparator auf die Schwelle Null und der dritte Komparator auf eine vorgegebene obere, oberhalb der Schwelle Null liegende Schwelle der Datensignale eingestellt ist; dem ersten Komparator ist eine erste Zeitstufe und dem zweiten Komparator eine zweite Zeitstufe nachgeordnet, wobei die mit der ersten Zeitstufe eingestellte Zeitdauer kürzer als die Dauer eines Datensignals und die mit der zweiten Zeitstufe eingestellte Zeitdauer kürzer als die Zeitdauer der ersten Zeitstufe aber länger als die maximal zu erwartende Anstiegszeit eines Datensignals ist; den beiden Zeitstufen und dem dritten Komparator ist ein gemeinsames UND-Glied zum Gewinnen eines Auslösesignals nachgeschaltet, und dem gemeinsamen UND-Glied ist eine zusätzliche Zeitstufe nachgeordnet, die beim Abfall des Auslösesignals an ihrem Ausgang ein dem jeweiligen relevanten Datensignal entsprechendes Auswerte-Datensignal abgibt. Mit einer derartigen Auswerteschaltung lassen sich zur Phasenjittermessung die jeweils ansteigenden Flanken relevanter Datensignale erfassen.

Um relevante Datensignale hinsichtlich der abfallenden Flanken untersuchen zu können, ist die Auswerteschaltung eingangsseitig mit drei von den Datensignalen parallel beaufschlagten Komparatoren versehen, von denen der erste Komparator auf eine vorgegebene untere Schwelle, der zweite Komparator auf die Schwelle Null und der dritte Komparator auf eine vorgegebene obere Schwelle für die Datensignale eingestellt ist; dem dritten Komparator ist eine dritte Zeitstufe und dem zweiten Komparator eine Zeitschaltung nachgeordnet, wobei die mit der dritten Zeitstufe eingestellte Zeitdauer kürzer als die Dauer eines Datensignals und die mit der Zeitschaltung eingestellte Zeitdauer kürzer als die Zeitdauer der dritten Zeitstufe aber länger als die maximal zu erwartende Abfallzeit eines Datensignals ist; der dritten Zeitstufe und der Zeitschaltung sowie dem ersten Komparator ist eine gemeinsame UND-Schaltung zum Gewinnen eines Auslöseimpulses nachgeschaltet und der gemeinsamen UND-Schaltung ist eine zusätzliche Zeitstufe nachgeordnet, die beim Abfall des Auslöseimpulses an ihrem Ausgang ein dem jeweiligen relevanten Datensignal entsprechendes Auswerte-Datensignal abgibt.

Häufig ist es notwendig bzw. vorgeschrieben, die relevanten Datensignale hinsichtlich ihrer ansteigenden und abfallenden Flanken gemeinsam untersuchen zu können. Dieser Anforderung wird eine vorteilhafte Ausführung der erfindungsgemäßen Schaltungsanordnung gerecht, bei der ausgehend von der erfindungsgemäßen Schaltungsanordnung zur Auswertung ansteigender Flanken an den Ausgang des dritten Komparators eine dritte Zeitstufe und an den Ausgang des zweiten Komparators zusätzlich eine Zeitschaltung angeschlossen ist, wobei die mit der dritten Zeitstufe eingestellte Zeitdauer kürzer als die Dauer eines Datensignals und die mit der Zeitschaltung eingestellte Zeitdauer kürzer als die Zeitdauer der dritten Zeitstufe aber länger als die maximal zu erwartende Abfallzeit eines Datensignals ist, der dritten Zeitstufe und der Zeitschaltung sowie dem ersten Komparator ist eine zweite gemeinsame UND-Schaltung zum Gewinnen eines Auslöseimpulses nachgeschaltet und der zweiten gemeinsamen UND-Schaltung ist die zusätzliche Zeitstufe nachgeordnet, die auch beim Abfall des von der zweiten gemeinsamen UND-Schaltung abgegebenen Auslöseimpulses an ihrem Ausgang ein dem jeweiligen relevanten Datensignal entsprechendes Auswerte-Datensignal abgibt.

Zur Erläuterung der Erfindung ist in
- Figur 1: ein Blockschaltbild einer Anordnung zur Durchführung des erfindungsgemäßen Verfahrens, in
- Figur 2: ein detaillierteres Ausführungsbeispiel der Schaltungsanordnung nach Figur 1 mit einem Phasendemodulator mit Integrator und in
- Figur 3: ein Ausführungsbeispiel der in Figur 2 dargestellten Auswerteschaltung wiedergegeben.

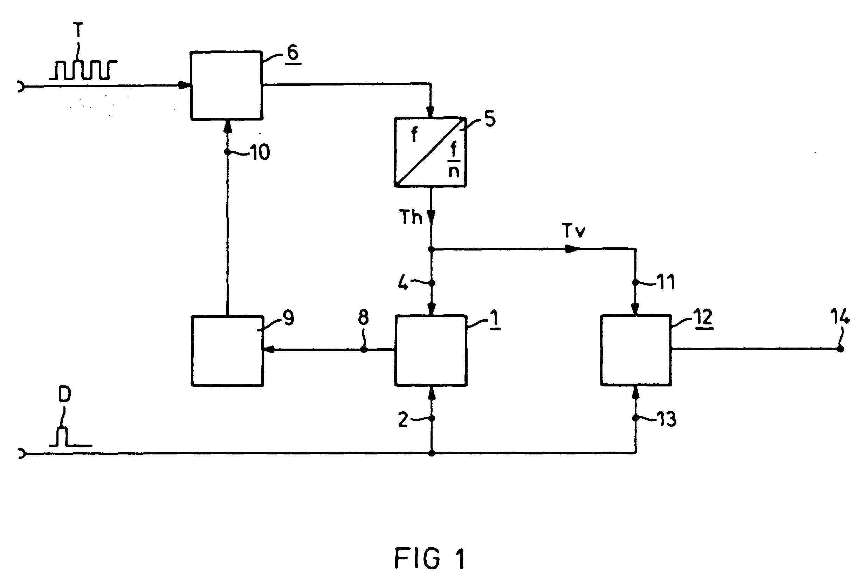

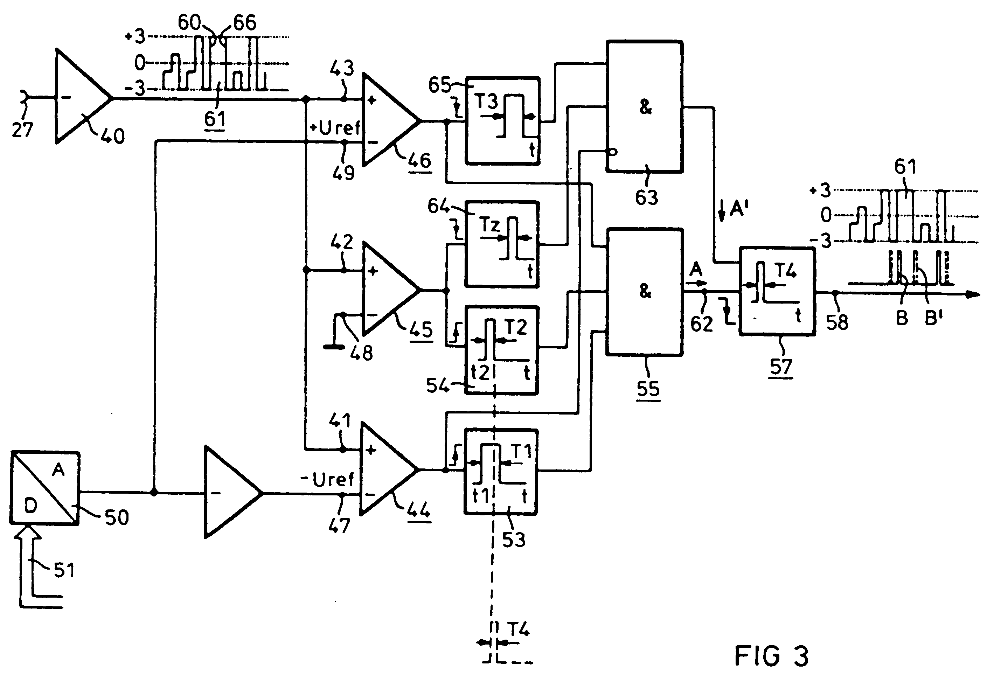

Die in Figur 1 dargestellte Anordnung zur Durchführung des erfindungsgemäßen Verfahrens zum Messen des Phasenjitters enthält unter anderem einen Phasenvergleicher 1, der an einem Eingang 2 mit einem Datensignal D beaufschlagt ist, bei dem es sich um ein aus einem Datensignal eines ISDN-Systems abgeleitetes Signal B bzw. B' handeln kann (vgl. Fig. 3). Ein weiterer Eingang 4 des Phasenvergleichers 1 ist über einen Frequenzteiler 5 mit einer Torschaltung 6 verbunden, die eingangsseitig mit einem vorgegebenen Taktsignal T beaufschlagt ist, bei dem es sich beispielsweise um ein aus dem Datensignal rückgewonnenen Systemtakt handeln kann. An einen Ausgang 8 des Phasenvergleichers 1 ist eine Steuereinrichtung 9 angeschlossen, die ausgangsseitig mit einem Steuereingang 10 der Torschaltung 6 verbunden ist.

Wie die Figur 1 ferner zeigt, ist mit dem Ausgang des Frequenzteilers 5 mit einem Eingang 11 auch ein Phasendemodulator 12 verbunden, der an einem weiteren Eingang 13 mit dem Datensignal D oder dem daraus abgeleiteten Signal B bzw. B' beaufschlagt ist. An einem Ausgang 14 des Phasendemodulators 12 ergibt sich ein Signal, das ein Maß für den Phasenjitter zwischen dem Datensignal D oder dem daraus abgeleiteten Signal B bzw. B' und dem vorgegebenen Taktsignal T darstellt.

Die in Figur 1 dargestellte Schaltungsanordnung zur Durchführung des erfindungsgemäßen Verfahrens arbeitet in folgender Weise:
Der Frequenzteiler 5 ist im Hinblick auf die relativ hohe Frequenz des vorgegebenen Taktsignals T so eingestellt, daß er an seinem Ausgang ein Takthilfssignal Th abgibt, das in der Frequenz der Frequenz des Datensignals D entspricht. Im Phasenvergleicher 1 wird das Takthilfssignal Th mit dem Datensignal D verglichen und über den Ausgang 8 an die Steuereinrichtung 9 ein Signal abgegeben, das den Unterschied in der Phase zwischen dem Takthilfssignal Th und dem Datensignal D wiedergibt. Der Phasenvergleicher 1 kann zu diesem Zwecke als taktflankengesteuertes D-Flip-Flop ausgeführt sein (vgl. z.B. H. Germer, N. Wefers "Meßelektronik", Band 2, 1990, Seiten 34 und 35). Stellt der Phasenvergleicher 1 eine Phasendifferenz fest, dann wird von der mit einem Mikroprozessor ausgerüsteten Steuereinrichtung 9 über den Steuereingang 10 die Torschaltung 6 so beaufschlagt, daß ein oder mehrere Impulse des vorgegebenen Taktsignals T unterdrückt werden. Dadurch wird die Phasenlage des Takthilfssignals Th im Vergleich zu der des Datensignals D verändert. Haben sich die Phasenlage des Takthilfssignals Th und des Datensignals D auf diese Weise soweit angenähert, daß eine mittels der Steuereinrichtung 9 vorgegebene Abweichung in der Phase zwischen den beiden Signalen unterschritten ist, dann wird für den mit einem in Fig. 1 nicht gezeigten Integrator versehenen Phasendemodulator 12 - ausgehend von dem Takthilfssignal Th - ein in seiner Phase durch die Steuereinrichtung 9 derart definiert verschobenes Taktvergleichssignal Tv erzeugt, daß die ansteigende Flanke des Datensignals D in die Mitte des rampenförmigen Ausgangssignals des Integrators des Phasenmodulators 12 fällt, wie im folgenden noch ausführlich dargelegt wird. Dadurch ist erreicht, daß bei der Demodulation der Phasenlage ein größtmöglicher Phasenhub ausgenutzt wird.

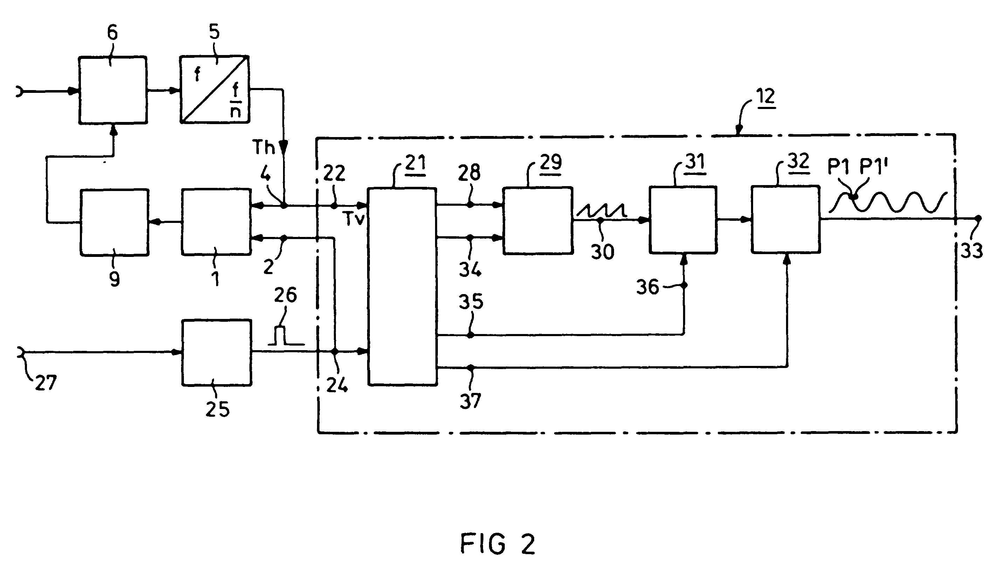

Aus Figur 2, in der mit der Figur 1 übereinstimmende Elemente mit gleichen Bezugszeichen versehen sind, geht hervor, daß der Phasendemodulator 12 eine Steuereinheit 21 aufweist, der über einen Eingang 22 das Taktvergleichssignal Tv zugeführt wird; mit dem Eingang 22 sind die Bausteine 1, 9, 6 und 5 in einer Weise verbunden, wie es aus Fig. 1 hervorgeht. Einem weiteren Eingang 24 der Steuereinheit 21 werden über eine Auswerteschaltung 25 Auswerte-Datensignale 26 zugeführt, die aus an einem Eingang 27 anstehenden ISDN-Datensignalen in der Auswerteschaltung 25 gebildet sind. Der weitere Eingang 24 ist auch mit einem Eingang 2 des Phasenvergleichers 1 verbunden.

Von der Steuereinheit 21 wird - gesteuert von dem Taktvergleichssignal Tv über einen Ausgang 28 ein Integrator 29 gestartet, der an seinem Ausgang 30 eine sägezahnförmig ansteigende Ausgangsspannung abgibt. Dem Integrator 29 ist ein Abtast-Halte-Glied 31 nachgeordnet, dem ein weiteres Abtast-Halte-Glied 32 nachgeschaltet ist. Der Ausgang 33 des weiteren Abtast-Halte-Gliedes 32 bildet den Ausgang der gesamten Schaltungsanordnung. Über einen weiteren Ausgang 34 kann die Steuereinheit 21 den Integrator 29 jeweils zurücksetzen.

Wie die Figur 2 ferner zeigt, ist über einen zusätzlichen Ausgang 35 die Steuereinheit 21 mit einem Steuereingang 36 des einen Abtast-Halte-Gliedes 31 verbunden; über diesen Eingang 36 wird das mit dem Start des Integrators 29 zum Abtasten veranlaßte Abtast-Halte-Glied 31 auf Halte-Funktion umgeschaltet, wenn der Steuereinheit 21 von der Auswerteschaltung 25 ein Auswerte-Datensignal 26 zugeführt wird. Bei dem Auswerte- Datensignal handelt es sich um ein Signal, das von der Auswerteschaltung 25 jeweils dann aus den eingehenden Datensignalen eines mehrstufigen Codes gebildet wird, wenn ein relevantes Datensignal, nämlich ein Datensignal über den vollen Signalhub, beispielsweise von - 3 bis + 3 verlaufendes Datensignal auftritt, wie es z.B. bei dem mehrstufigen Code 2B1Q der Fall ist. Der von dem einen Abtast-Halte-Glied 31 festgehaltene Abtastwert wird mittels eines über einen vierten Ausgang 37 der Steuereinheit 21 gegebenen Signals von dem weiteren Abtast-Halte-Glied 32 festgehalten. Der festgehaltene Wert bildet einen Meßpunkt (z.B. P1) auf dem Signal am Ausgang 33.

Hat das Ausgangssignal des Integrators 29 einen Sägezahn durchlaufen, dann erfolgt ein Zurücksetzen von Integrator 29 und Abtast-Halte-Glied 31 und ein Wiederstart von der Steuereinheit 21 aus, und es läuft derselbe Vorgang ab, wie er eben beschrieben worden ist, sofern ein weiteres Auswerte-Datensignal auf das erste Auswerte-Datensignal folgt. Ist dies nicht der Fall, tritt also am Eingang 24 der Steuereinheit 1 ein Auswerte-Datensignal nicht auf, erfaßt das eine Abtast-Halte-Glied 31 keinen neuen Abtastwert, und es wird das weitere Abtast-Halteglied 32 nicht auf Abtasten zur Übernahme des Signals von dem einen Abtast-Halte-Glied 11 geschaltet. Es wird dann der durch das weitere Abtast-Halte-Glied 32 festgehaltene Abtast-Halte-Glied des vorangehenden Zyklus weitergehalten und am Ausgang 33 ein Abtastwert P1' erzeugt, der dem Wert P1 entspricht, nur mit dem Unterschied, daß er zeitlich geringfügig versetzt ist, weil er aus einem späteren Zyklus stammt.

Tritt in einem folgenden Meßzyklus wiederum ein Auswerte-Datensignal 26 am Eingang 24 der Steuereinheit 21 auf, dann wird über den zusätzlichen Ausgang 37 von der Steuereinheit 21 das weitere Abtast-Halte-Glied 32 auf Abtasten geschaltet, so daß es nunmehr bereit ist, einen neuen Abtastwert von dem vorgeschalteten einen Abtast-Halte-Glied 31 zu übernehmen.

In Figur 3 ist ein Ausführungsbeispiel der Auswerteschaltung 25 nach Figur 2 wiedergegeben. Die Figur 3 läßt erkennen, daß Datensignale eines ISDN-Systems im quarternären Code über den Eingang 27 und einen Eingangsverstärker 40 parallel an die nichtinvertierenden Eingänge 41,42 und 43 eines ersten Komparators 44, eines zweiten Komparators 45 und eines dritten Komparators 46 angeschlossen sind. Die Komparatoren 44 bis 46, die vorzugsweise als Differenzverstärker ausgebildet sind, liegen bezüglich ihrer invertierenden Eingänge 47, 48 und 49 an unterschiedlichen Bezugsspannungen, die über einen Digital-Analog-Umsetzer 50 bereitgestellt werden, der seinerseits eingangsseitig an einem Rechner-Bus 51 liegt. Auf diese Weise läßt sich der Komparator 44 auf eine untere Schwelle von etwa - 3, der zweite Komparator 45 auf eine Schwelle Null und der dritte Komparator 46 auf eine obere Schwelle von etwa + 3 einstellen.

Die Figur 3 läßt ferner erkennen, daß dem einen Komparator 44 eine Zeit stufe 53 und dem zweiten Komparator 45 eine zweite Zeitstufe 54 nachgeordnet ist. Beide Zeitstufen 53 und 54 sind ausgangsseitig mit einem UND-Glied 35 verbunden, das außerdem unmittelbar an den dritten Komparator 46 angeschlossen ist.

Ausgangsseitig ist das UND-Glied 55 mit einer zusätzlichen Zeit stufe 57 verbunden, deren Ausgang 58 mit dem weiteren Eingang 24 der Steuereinheit 1 (vgl. Fig. 2) verbunden ist.

Die in Figur 3 dargestellte Auswerteschaltung arbeitet in folgender Weise:
Soll gerade eine ansteigende Flanke 60 eines relevanten Datensignals 61 zur Phasenjittermessung erfaßt werden, dann wird durch diese Flanke 60 zu einem Zeitpunkt t1 die erste Zeitstufe 53 gestartet. Die mit dieser Zeitstufe eingestellte Zeitdauer T1 ist etwas kürzer als die Zeitdauer des relevanten Datensignals 61. Zu einem etwas späteren Zeitpunkt t2 wird beim Nulldurchgang der Flanke 60 die zweite Zeit stufe 54 gestartet, deren eingestellte Zeitdauer T2 kürzer als die Zeitdauer T1 der ersten Zeitstufe 53 aber länger als die maximal zu erwartende Anstiegszeit des relevanten Datensignals 61 ist. Wenn das relevante Datensignal 61 die obere Schwelle + 3 erreicht, wird in einem kurzen Zeitintervall von den beiden Zeitstufen 53 und 54 und vom dritten Komparator 46 das UND-Glied 55 gemeinsam beaufschlagt. Figur 3 läßt erkennen, daß das daraufhin am Ausgang 62 des UND-Gliedes 55 entstehende Auslösesignal A mit dem Abfall der zweiten Zeitstufe 54 seinerseits abfällt, womit die zusätzliche Zeitstufe 57 gestartet wird. Es entsteht dann das der ansteigenden Flanke des relevanten Datensignals 61 entsprechende Auswerte-Datensignal B, das in den Kurvenverläufen am Ausgang 58 der zusätzlichen Zeitstufe 57 mit durchgehenden Linien eingezeichnet ist. Darüber ist noch einmal zur besseren Verständlichkeit der Verlauf der eingangsseitigen Datensignale wiedergegeben.

Figur 3 läßt ferner erkennen, daß der erste Komparator 44 direkt mit einem invertierenden Eingang einer UND-Schaltung 63 verbunden ist; ein weiterer Eingang der UND-Schaltung 63 ist über eine Zeitschaltung 64 mit dem Ausgang des zweiten Komparators 45 und ein zusätzlicher Eingang der UND-Schaltung 63 ist über eine dritte Zeitstufe 65 mit dem Ausgang des dritten Komparators 46 verbunden. Beim Abfall des relevanten Datensignals 61 bzw. bei dessen abfallender Flanke 66 wird am Ausgang der UND-Schaltung 63 ein Auslöseimpuls A' erzeugt, auf den hin von der zusätzlichen Zeitstufe 57 ein weiteres Auswerte-Datensignal B' abgegeben wird, das am Ausgang 58 der zusätzlichen Zeitstufe 57 strichliert dargestellt ist.

## Patentansprüche

1. Verfahren zum Messen des Phasenjitters eines Datensignals bei dem,
- aus einem vorgegebenen Taktsignal (T) mit Hilfe einer Torschaltung (6) und einer Frequenzteilung ein Takthilfssignal (Th) abgeleitet wird, dessen Frequenz der Frequenz des Datensignals (D,26,B,B') entspricht,
- die Phasendifferenz zwischen dem Datensignal (D,26,B,B') und dem Takthilfssignal (Th) ermittelt wird,
- bei Feststellung einer eine vorgegebene Abweichung in der Phase zwischen dem Datensignal (D,26,B,B') und dem Takthilfssignal (Th) überschreitenden Abweichung die Torschaltung (6) unter Gewinnung eines geänderten Takthilfssignals so gesteuert wird, daß die Abweichung in der Phase unter die vorgegebene Abweichung absinkt,
- danach aus dem geänderten Takthilfssignal (Th) ein Taktvergleichssignal (Tv) gebildet wird, welches eine solche Phasenlage zu dem geänderten Takthilfssignal aufweist, daß bei einem eingangsseitig mit dem Taktvergleichssignal (Tv) und dem Datensignal (D,26,B,B') beaufschlagten Phasendemodulator (12) mit einem ein rampenförmiges Signal erzeugenden Integrator (29) und nachgeordnetem Abtast-Halte-Glied (31) bei einem Phasenjitter Null die ansteigende Flanke des entsprechenden Impulses des Datensignals (D,26,B,B') zeitlich in die Mitte des rampenförmigen Signals fällt, und
- anschließend zum Messen des Phasenjitters das Datensignal (D,26,B,B') und das Taktvergleichssignal (Tv) dem Phasendemodulator (12) zugeführt werden, wobei mittels des Taktvergleichssignals (Tv) jeweils der Integrator (29) gestartet und das Abtast-Halte-Glied (31) auf Abtast-Funktion geschaltet und mittels des Datensignals (D,26,B,B') jeweils das Abtast-Halteglied (31) auf Halte-Funktion umgeschaltet wird.

2. Verfahren nach Anspruch 1,
**dadurch gekennzeichnet,** daß
- das geänderte Takthilfssignal (Th) durch Unterdrücken von jeweils so vielen Impulsen des vorgegebenen Taktsignals (T) durch entsprechende Ansteuerung der Torschaltung (6) von einer Steuereinrichtung (9) aus gewonnen wird, bis die Abweichung in der Phase zwischen dem Datensignal (D) und dem geänderten Takthilfssignal (Th) unter die vorgegebene Abweichung gesunken ist.

3. Verfahren nach Anspruch 1 oder 2,
**dadurch gekennzeichnet,** daß
- das Taktvergleichssignal (Tv) durch Unterdrücken einer derartigen Anzahl von Impulsen des Taktsignals (T) durch Ansteuerung der Torschaltung (6) von der Steuereinrichtung (9) aus gewonnen wird, daß das Taktvergleichssignal (Tv) gegenüber dem geänderten Takthilfssignal (Th) um eine der halben Anstiegszeit des rampenförmigen Ausgangssignals des Integrators (29) entsprechende Zeitdauer verschoben ist.

4. Verfahren nach einem der vorangehenden Ansprüche,
**dadurch gekennzeichnet,** daß
- zum Messen des Phasenjitters von ISDN-Datensignalen mehrstufiger Codes in einer Auswerteschaltung (25) aus den Datensignalen diejenigen Datensignale als relevante Datensignale (61) erfaßt werden, die über den durch den jeweiligen Code vorgegebenen vollen Signalhub verlaufen, und einem Phasenvergleicher (1), der die Phasendifferenz zwischen dem Datensignal (26,B,B') und dem Takthilfssignal (Th) ermiltelt, und dem Phasendemodulator (12) entsprechende Auswerte-Signale (B,B') als Datensignale (26,B,B') zugeführt werden,
- von einer der Auswerteschaltung (25) nachgeordneten, in dem Phasendemodulator (12) enthaltenen Steuereinheit (21) durch das Takthilfssignal (Th) der Integrator (29) gestartet und das dem Integrator (29) nachgeordnetes Abtast-Halte-Glied (31) zum Abtasten veranlaßt wird,
- von einem relevanten Datensignal (61) angestoßen von der Steuereinheit (21) das Abtast-Halte-Glied (31) auf Halte-Funktion und ein nachgeschaltetes weiteres Abtast-Halte-Glied (32) zur Übernahme des festgehaltenen Abtastwertes auf Halte-Funktion geschaltet wird, bevor das erste Abtast-Halte-Glied bei einem Wiederholungsstart des Integrators (29) wieder zum Abtasten veranlaßt wird und
- der jeweils übernommene Abtastwert am Ausgang des weiteren Abtast-Halte-Gliedes (32) als Meßwert des Phasenjitters abgenommen wird.

5. Schaltungsanordnung zum Messen des Phasenjitters eines Datensignals bei der,
- ein Phasenvergleicher (1) an einem Eingang (2) mit dem Datensignal (D,26,B,B') beaufschlagt ist und mit einem weiteren Eingang (4) über einen ein Takthilfssignal (Th) abgebenden Frequenzteiler (5) an eine Torschaltung (6) angeschlossen ist, die eingangsseitig an einem vorgegebenen Taktsignal (T) liegt, wobei die Frequenz des Takthilfssignals (Th) der Frequenz des Datensignals (D,26,B,B') entspricht,
- an den Phasenvergleicher (1) ausgangsseitig eine Steuereinrichtung (9) angeschlossen ist, welche die ihr nachgeordnete Torschaltung (6) bei Feststellung einer eine vorgegebene Abweichung in der Phase zwischen dem Datensignal (D,26,B,B') und dem Takthilfssignal (Th) überschreitenden Abweichung in der Phase so steuert, daß durch Änderung des Takthilfssignals (Th) die Abweichung in der Phase unter die vorgegebene Abweichung absinkt,
- ein Phasendemodulator (12) eine mit dem Taktvergleichssignal (Tv) und dem Datensignal (D,26,B,B') beaufschlagte Steuereinheit (21) aufweist, an die ein Integrator (29) mit einem nachgeordneten Abtast-Halte-Glied (31) angeschlossen ist, wobei das Taktvergleichssignal (Tv) aus dem geänderten Takthilfssignal durch eine derartige Änderung der Phasenlage mittels Steuerung der Torschaltung (6) durch die Steuereinrichtung (9) gewonnen ist, daß bei der Phasendemodulation bei einem Phasenjitter Null die ansteigende Flanke des entsprechenden Datensignals (D,26,B,B') zeitlich in die Mitte des rampenförmigen Signals des Integrators (29) fällt, und
- am Ausgang des Abtast-Halte-Gliedes (31) ein dem Phasenjitter angebendes Signal auftritt.

6. Schaltungsanordnung nach Anspruch 5,
**dadurch gekennzeichnet,** daß
- zum Messen des Phasenjitters von ISDN-Datensignalen mehrstufiger Codes eine Auswerteschaltung (25) vorhanden ist, die aus den Datensignalen diejenigen Datensignale als relevante Datensignale (61) erfaßt, die über den durch den jeweiligen Code vorgegebenen vollen Signalhub verlaufen,
- die Auswerteschaltung (25) ausgangsseitig mit dem einen Eingang (2) des Phasenvergleichers (1) und mit einem Eingang einer in dem Phasendemodulator (12) eingangsseitig vorgesehenen Steuereinheit (21) verbunden ist, von der auf das Takthilfssignal (Th) hin der Integrator (29) gestartet und das dem Integrator (29) nachgeordnete Abtast-Halte-Glied (31) zum Abtasten veranlaßt wird und von der auf ein relevantes Datensignal (61) hin das Abtast-Halte-Glied (31) auf Halte-Funktion und ein nachgeschaltetes weiteres Abtast-Halte-Glied (32) zur Übernahme des festgehaltenen Abtastwertes auf Halte-Funktion geschaltet wird, bevor das eine Abtast-Halteglied bei einem Wiederholungsstart des Integrators (29) wieder zum Abtasten veranlaßt wird, und
- am Ausgang des weiteren Abtast-Halte-Gliedes (32) der Meßwert des jeweiligen Phasenjitters auftritt.

7. Schaltungsanordnung nach Anspruch 6,
**dadurch gekennzeichnet,** daß
- die Auswerteschaltung (25) eingangsseitig mit drei von den Datensignalen (D) parallel beaufschlagten Komparatoren (44,45,46) versehen ist, von denen der erste Komparator (44) auf eine vorgegebene, unterhalb einer Schwelle Null liegende untere Schwelle, der zweite Komparator (45) auf die Schwelle Null und der dritte Komparator (46) auf eine vorgegebene, oberhalb der Schwelle Null liegende obere Schwelle der Datensignale (D) eingestellt ist,
- dem ersten Komparator (44) eine erste Zeitstufe (53) und dem zweiten Komparator (45) eine zweite Zeitstufe (54) nachgeordnet ist, wobei
- die mit der ersten Zeitstufe (53) eingestellte Zeitdauer (T1) kürzer als die Dauer eines Datensignals und die mit der zweiten Zeitstufe (54) eingestellte Zeitdauer (T2) kürzer als die Zeitdauer (T1) der ersten Zeitstufe (53) aber länger als die maximal zu erwartende Anstiegszeit eines Datensignals ist,
- den beiden Zeitstufen (53,54) und dem dritten Komparator (46) ein gemeinsames UND-Glied (55) zum Gewinnen eines Auslösesignals (A) nachgeschaltet ist und
- dem gemeinsamen UND-Glied (55) eine zusätzliche Zeitstufe (57) nachgeordnet ist, die beim Abfall des Auslösesignals (A) an ihrem Ausgang (58) ein dem jeweiligen relevanten Datensignal (61) entsprechendes Auswerte-Datensignal (B) abgibt.

8. Schaltungsanordnung nach Anspruch 6,
**dadurch gekennzeichnet,** daß
- die Auswerteschaltung (25) eingangsseitig mit drei von den Datensignalen parallel beaufschlagten Komparatoren (44,45,46) versehen ist, von denen der erste Komparator (44) auf eine vorgegebene, unterhalb einer Schwelle Null liegende untere Schwelle, der zweite Komparator (45) auf die Schwelle Null und der dritte Komparator (46) auf eine vorgegebene, oberhalb der Schwelle Null liegende obere Schwelle für die Datensignale (D) eingestellt ist,
- dem dritten Komparator (46) eine dritte Zeitstufe (65) und dem zweiten Komparator (45) eine Zeitschaltung (64) nachgeordnet ist, wobei
- die mit der dritten Zeitstufe (65) eingestellte Zeitdauer (T3) kürzer als die Dauer eines Datensignals und die mit der Zeitschaltung (64) eingestellte Zeitdauer (Tz) kürzer als die Zeitdauer (T3) der dritten Zeitstufe (65) aber länger als die maximal zu erwartende Abfallzeit eines Datensignals ist,
- der dritten Zeitstufe (65) und der Zeitschaltung (64) sowie dem ersten Komparator (44) eine gemeinsame UND-Schaltung (63) zum Gewinnen eines Auslöseimpulses (A') nachgeschaltet ist und
- der gemeinsamen UND-Schaltung (63) eine zusätzliche Zeitstufe (57) nachgeordnet ist, die beim Abfall des Auslöseimpulses (A') an ihrem Ausgang (58) ein dem jeweiligen relevanten Datensignal (61) entsprechendes Auswerte-Datensignal (B') abgibt.

9. Schaltungsanordnung nach Anspruch 7,
**dadurch gekennzeichnet,** daß
- an den Ausgang des dritten Komparators (46) eine dritte Zeitstufe (65) und an den Ausgang des zweiten Komparators (45) zusätzlich eine Zeitschaltung (64) angeschlossen ist, wobei
- die mit der dritten Zeitstufe (65) eingestellte Zeitdauer (T3) kürzer als die Dauer eines Datensignals und die mit der Zeitschaltung (64) eingestellte Zeitdauer (Tz) kürzer als die Zeitdauer (T3) der dritten Zeitstufe (65) aber länger als die maximal zu erwartende Abfallzeit eines Datensignals ist,
- der dritten Zeitstufe (65) und der Zeitschaltung (64) sowie dem ersten Komparator (44) eine zweite gemeinsame UND-Schaltung (63) zum Gewinnen eines Auslöseimpulses (A') nachgeschaltet ist und
- der zweiten gemeinsamen UND-Schaltung (63) die zusätzliche Zeitstufe (57) nachgeordnet ist, die auch beim Abfall des von der zweiten gemeinsamen UND-Schaltung (63) abgegebenen Auslöseimpulses (A') an ihrem Ausgang (58) ein dem jeweiligen relevanten Datensignal entsprechendes Auswerte-Datensignal (B') abgibt.

## Claims

1. A process for measuring phase jitter of a data signal wherein
- an auxiliary clock signal (Th) is derived from a given clock signal (T) by means of a gate circuit (6) and frequency dividing, the frequency of said auxiliary clock signal corresponding to the frequency of the data signal (D, 26, B, B'),
- the phase difference between said data signal (D, 26, B, B') and said auxiliary clock signal (Th) is determined,
- if the phase between said data signal (D, 26, B, B') and said auxiliary clock signal (Th) is found to exceed a predetermined value, said gate circuit (6) is controlled such that the phase deviation decreases to a value below the predetermined deviation, thereby obtaining a changed auxiliary clock signal,
- subsequently, a comparative clock signal (Tv) is formed from said changed auxiliary clock signal (Th), the phase of which former is located with respect to said changed auxiliary clock signal such that in a phase demodulator (12) which receives said comparative clock signal (Tv) and said data signal (D, 26, B, B') at its input and which includes an integrator (29) generating a ramp signal and a post-connected sample-and-hold member (31), the occurrence in time of the rising signal edge of the corresponding pulse of said data signal (D, 26, B, B') falls into the centre of said ramp signal, if there is zero phase jitter, and
- subsequently, for measuring the phase jitter, said data signal (D, 26, B, B') and said comparative clock signal (Tv) are transmitted to said phase demodulator (12) where said comparative clock signal (Tv) is used both to start said integrator (29) and to switch said sample-and-hold member (31) to its sampling function, and said data signal (D, 26, B, B') is used to switch said sample-and-hold member (31) to its holding function.

2. The process of claim 1 wherein
- said changed auxiliary clock signal (Th) is obtained by controlling said gate circuit (6) by means of a control unit (9) such that it suppresses as many pulses of said given clock signal (T) at a time until the phase deviation between said data signal (D) and said changed auxiliary clock signal (Th) falls below the predetermined deviation value.

3. The process of claims 1 or 2 wherein
- said comparative clock signal (Tv) is obtained by controlling said gate circuit (6) by means of said control unit (9) in such a manner that it suppresses such a number of pulses of said clock signal (T) that said comparative clock signal (Tv) is shifted in time with respect to said changed auxiliary clock signal (Th) by a time period corresponding to half of the rise time of the output ramp signal from said integrator (29).

4. The process of one of the preceding claims wherein
- for measuring phase jitter of ISDN data signals having multi-stage codes, an evaluation circuit (25) determines those data signals of the plurality of data signals as relevant data signals (61) which pass the full signal level swing given by the respective code, and a phase comparator (1), which determines the phase difference between said data signal (26, B, B') and said auxiliary clock signal (Th), and said phase demodulator (12) receive corresponding evaluation signals (B, B') as data signals (26, B, B').
- said integrator (29) is started by said auxiliary clock signal (Th) from a control unit (21) connected after said evaluation circuit (25) and contained in said phase demodulator (12), and said sample-and-hold member (31) connected after said integrator (29) is caused to start sampling,
- by a relevant data signal (61) initiated by the control unit (21) said sample-and-hold member (31) is switched to its holding function, and a post-connected further sample-and-hold member (32) for taking over the held sample is switched to its holding function, before said first sample-and-hold member is caused to start sampling again upon a repeated start of said integrator (29), and
- the sample which has been taken over in each case is output by said further sample-and-hold member (32) as the measured phase jitter value.

5. A circuitry for measuring phase jitter of a data signal wherein
- one input (2) of a phase comparator (1) receives said data signal (D, 26, B, B'), and a further input (4) thereof is connected to a gate circuit (6) via a frequency divider (5) outputting an auxiliary clock signal (Th), the input of said gate circuit (6) receiving a predetermined clock signal (T), with the frequency of said auxiliary clock signal (Th) corresponding to the frequency of said data signal (D, 26, B, B'),
- the output of said phase comparator (1) is connected to a control unit (9) which - upon detection of a phase deviation between said data signal (D, 26, B, B') and said auxiliary clock signal (Th) which exceeds a predetermined deviation value - controls said gate circuit (6) connected thereafter in such a manner that
- by changing said auxiliary clock signal (Th) - the phase deviation falls below the predetermined value,
- a phase demodulator (12) includes a control unit (21) which receives said comparative clock signal (Tv) and said data signal (D, 26, B, B'), with an integrator (29), followed by a sample-and-hold member (31), being connected to said control unit (21), said comparative clock signal (Tv) having been obtained from said changed auxiliary clock signal by changing the phase position by controlling said gate circuit (6) via said control unit (9) such that during phase demodulation, the occurrence in time of the rising edge of the corresponding data signal (D, 26, B, B') falls into the centre of the ramp signal of the integrator (29), if there is zero phase jitter, and
- a signal indicating the phase jitter is output by said sample-and-hold member (31).

6. The circuitry of claim 5 wherein
- for measuring the phase jitter of ISDN data signals having multi-stage codes, an evaluation circuit (25) is provided which determines those data signals of the plurality of data signals as relevant data signals (61) which pass the entire signal level swing as defined by the respective code,
- the output of said evaluation circuit (25) is connected to the one input (2) of said phase comparator (1) and to one input of said control unit (21) provided at the input of the phase demodulator (12), said control unit (21) - in response to said auxiliary clock signal (Th) - starting said integrator (29) causing said sample-and-hold member (31) post-connected to said integrator (29) to sample and - in response to a relevant data signal (61) - causing said sample-and-hold member (31) to switch to its holding function, and a post-connected further sample-and-hold member (32) for taking over the held sample to switch to its holding function before the one sample-and-hold member is caused to sample again in response to a repeated start of said integrator (29), and
- the respective measured phase jitter value is output by said further sample-and-hold member (32).

7. The circuitry of claim 6 wherein
- the input of said evaluation circuit (25) includes three comparators (44, 45, 46) receiving said data signals (D) in parallel, the first comparator (44) of which is set to a predetermined lower threshold which is below a zero threshold, the second comparator (45) is set to the zero threshold, and the third comparator (46) is set to an upper threshold of the data signals (D) which is above the zero threshold,
- connected after said first comparator (45) is a first timer (53) and connected after said second comparator is a second timer (54), wherein
- the time period (T1) set by means of said first timer (53) is shorter than the duration of a data signal, and the time period (T2) set by means of the second timer (54) is shorter than the time period (T1) of said first timer (53) but longer than the maximum anticipated rise time of a data signal,
- connected after said two timers (53, 54) and said third comparator (46) is a common AND gate (55) for obtaining a trigger signal (A), and
- connected after said common AND gate (55) is an additional timer (57) which outputs a corresponding evaluation data signal (B) corresponding to the respective relevant data signal (61) when the trigger signal (A) drops at its output (58).

8. The circuitry of claim 6 wherein
- the input of said evalution circuit (25) includes three comparators (44, 45, 46) which receive the data signals in parallel, the first comparator (44) of which is set to a predetermined lower threshold which is below a zero threshold, the second comparator (45) is set to the zero threshold, and the third comparator (46) is set to a predetermined upper threshold for said data signals (D) which is above the zero threshold,
- connected after said third comparator (46) is a third timer (65) and connected after said second comparator (45) is a timer circuit (64) wherein
- the time period (T3) set by means of said third timer (65) is shorter than the duration of a data signal, and the time period (Tz) set by means of said timer circuit (64) is shorter than the time period (T3) of said third timer (65), but longer than the maximum anticipated decay time of a data signal,
- connected after said third timer (65) and said timer circuit (64) as well as said first comparator (44) is a common AND gate (63) for obtaining a trigger pulse (A'), and
- connected after said common AND gate (63) is an additional timer (57) which - in response to the decay of said trigger pulse (A') - outputs an evaluation data signal (B') corresponding to the respective relevant data signal (61) at its output (58).

9. The circuitry of claim 7 wherein
- a third timer (65) is connected to the output of said third comparator (46) and a timer circuit (64) is additionally connected to the output of said second comparator (45), wherein
- the time period (T3) set by means of said third timer (65) is shorter than the duration of a data signal, and the time period (Tz) set by means of the timer circuit (64) is shorter than the time period (T3) of said third timer (65), but longer than the maximum anticipated decay time of a data signal,
- connected after said third timer (65) and said timer circuit (64) as well as said first comparator (44) is a second common AND gate (63) for obtaining a trigger pulse (A'), and
- connected after said second common AND gate (63) is said additional timer (57) which outputs an evaluation data signal (B') corresponding to the respective relevant data signal also if the trigger pulse (A') output by said second common AND gate (63) drops at its output (58).

## Revendications

1. Procédé de mesure de bruit de phase de signaux de données par lequel
- un signal de rythme secondaire (Th), dont la fréquence correspond à la fréquence du signal de données (D, 26, B, B'), est dérivé d'un signal de rythme initial (T) à l'aide d'un circuit porte (6) et d'une démultiplication de fréquence,
- la différence de phase entre le signal de données (D, 26, B, B') et le signal de rythme secondaire (Th) est déterminée,
- si une déviation dépasse une déviation fixée de la phase entre le signal de données (D, 26, B, B') et le signal de rythme secondaire (Th), le circuit porte (6) est régulé par la libération d'un signal de rythme secondaire modifié, de telle sorte que la déviation de phase descende sous une déviation fixée,
- un signal de rythme de comparaison (Tv) est ensuite créé à partir du signal de ryhtme secondaire (Th), dont la position de phase par rapport au signal de rythme secondaire modifié est telle, que pour un démodulateur de phase (12) alimenté côté entrée par le signal de rythme de comparaison (Tv) et le signal de donnée (D, 26, B, B') et comportant un intégrateur (29) créant un signal en rampe et un échantillonneur-bloqueur subordonné (31), le flanc de l'implusion du signal de données (D, 26, B, B') correspondante tombe temporellement au milieu du signal en rampe lorsque le bruit de phase est nul, et
- le signal de données (D, 26, B, B') et le signal de rythme de comparaison (Tv) sont transmis par la suite au démodulateur de phase (12) pour la mesure du bruit de phase, le signal de rythme de comparaison activant l'intégrateur (29) et commutant l'échantillonneur-bloqueur (31) sur fonction de balayage et le signal de données (D, 26, B, B') commutant l'échantillonneur-bloqueur sur fonction de blocage.

2. Procédé suivant la revendication 1,
**caractérisé en ce que**
- le signal de rythme secondaire modififié (Th) est obtenu en supprimant autant d'impulsions du signal de rythme initial (T) par le réglage correspondant du circuit porte (6) à partir du dispositif de commande (9), jusqu'à ce que la déviation de phase entre le signal de données (D) et le signal de rythme modifié (Th) soit inférieure à la déviation fixée.

3. Procédé suivant les revendications 1 et 2,
**caractérisé en ce que**
- le signal de rythme de comparaison (Tv) est obtenu en supprimant autant d'impulsions du signal de rythme (T) par le réglage du circuit porte (6) à partir du dispositif de commande (9), jusqu'à ce que le signal de rythme de comparaison (Tv) soit décalé d'un intervalle de temps égal à la moitié du temps de montée du signal en rampe de sortie de l'intégrateur (29) par rapport au signal de rythme secondaire (Th).

4. Procédé suivant une des revendications précédentes,
**caractérisé en ce que,**
- dans un circuit de sélection (25), pour mesurer le bruit de phase de signaux de données RNIS de codes à plusieurs niveaux, des signaux de données considérés comme caractéristiques puisqu'ils sont transmis sur toute la longueur de déviation de signal fixée par le code correspondant sont triés des autres signaux de données, et ces signaux de repérage (B, B') sont envoyés en tant que signaux de données (26, B, B') à un indicateur de phase (1) qui calcule la différence de phase entre le signal de données (26, B, B') et le signal de rythme secondaire (Th) ainsi qu'au démodulateur de phase (12),
- à partir d'une unité de commande (21) subordonnée au circuit de sélection (25) et contenue dans le démodulateur de phase (12), le signal de rythme secondaire active l'intégrateur (29) et mène l'échantillonneur-bloqueur (31) subordonné à l'intégrateur (29) à échantillonner,
- un signal de données caractéristique (61) envoyé par l'unité de commande (21) commute l'échantillonneur-bloqueur (31) sur fonction de blocage et, pour récupérer la valeur d'échantillonnage retenue, commute aussi un échantillonneur-bloqueur (32) suivant sur fonction de blocage, avant que le premier échantillonneur-bloqueur ne soit mené à échantillonner par un redémarrage de l'intégrateur (29), et
- la valeur d'échantillonnage recueillie à la sortie de l'échantillonneur-bloqueur suivant (32) est saisie comme valeur de mesure du bruit de phase.

5. Constitution de circuit pour la mesure du bruit de phase d'un signal de données dans laquelle
- un indicateur de phase (1) est alimenté à une entrée (2) par un signal de données (D, 26, B, B') et connecté par un démultiplicateur de fréquence (5) transmettant un signal de rythme secondaire (Th) sur une autre entrée (4) à un circuit porte (6) recevant côté entrée un signal de rythme initial (T), la fréquence du signal de rythme secondaire (Th) correspondant à la fréquence du signal de données (D, 26, B, B'),
- un dispositif de commande (9) est connecté à l'indicateur de phase (1) côté sortie, réglant le circuit porte (6) lui étant subordonné lors de la détection d'une déviation de la phase entre le signal de données (D, 26, B, B') et le signal de rythme secondaire (Th) dépassant la déviation de phase fixée, de telle sorte que par modification du signal de rythme secondaire (Th) la déviation de phase descende sous la déviation fixée,
- un démodulateur de phase (12) comprend une unité de commande (21) alimentée par le signal de rythme de comparaison (Tv) et le signal de données (D, 26, B, B'), à laquelle est connecté un intégrateur (29) subordonné d'un échantillonneur-bloqueur (31), le signal de rythme de comparaison (Tv) étant obtenu à partir du signal de rythme secondaire modifié par une telle modification de la position de phase grâce au moyen du circuit porte (6) par le dispositif de commande (9), que lors d'une démodulation de phase pour un bruit de phase nul, le flanc croissant du signal de données (D, 26, B, B') correspondant tombe temporellement au milieu du signal en rampe de l'intégrateur (29), et
- un signal indiquant le bruit de phase apparaît à la sortie de l'échantillonneur-bloqueur (31).

6. Constitution de circuit suivant la revendication 5,
**caractérisé en ce que,**
- pour mesurer le bruit de phase de signaux de données RNIS de codes à plusieurs niveaux, un circuit de sélection (25) est disponible saisissant parmi les signaux de données ceux considérés comme caractéristiques (61) puisqu'ils sont transmis sur toute la longueur de déviation de signal fixée par le code correspondant,
- le circuit de sélection (25) est connecté côté sortie avec une entrées (2) de l'indicateur de phase (1) et une entrée d'une unité de commande (21) prévue côté entrée dans le démodulateur de phase (12), qui active l'intégrateur (29) par le signal de rythme secondaire (Th) et mène l'échantillonneur-bloqueur (31) subordonné à l'intégrateur (29) à échantillonner, et qui par un signal de données caractéristique (61) commute l'échantillonneur-bloqueur (31) sur fonction de blocage et un échantillonneur-bloqueur suivant (32) aussi sur fonction de blocage pour récupérer la valeur d'échantillonnage retenue, avant que le premier échantillonneur-bloqueur ne soit mené à échantillonner par un redémarrage de l'intégrateur (29), et
- la valeur de mesure du bruit de phase correspondant apparaît à la sortie de l'échantillonneur-bloqueur suivant (32).

7. Constitution de circuit suivant la revendication 6,
**caractérisé en ce que,**
- le circuit de sélection (25) comporte côté entrée trois comparateurs (44, 45, 46) alimentés en parallèle par les signaux de données (D), dont le premier (44) est réglé sur un seuil défini, inférieur au seuil zéro, le deuxième comparateur (45) sur le seuil zéro et le troisième comparateur (46) sur un seuil défini, supérieur au seuil zéro des signaux de données (D),
- un premier temporisateur (53) est subordonné au premier comparateur (44) et un deuxième temporisateur (54) au deuxième comparateur (45),
- l'intervalle de temps (T1) réglé sur le premier temporisateur (53) étant plus petit que la durée d'un signal de données et l'intervalle de temps (T2) réglé sur le deuxième temporisateur (54) étant plus petit que l'intervalle de temps (T1) du premier temporisateur (53), mais plus long que le temps de montée maximum possible d'un signal de données,
- une porte ET (55) commune aux deux temporisateurs (53, 54) et au troisième comparateur (46) leur est subordonnée pour créer un signal de déclenchement (A) et
- un temporisateur supplémentaire (57) est subordonné à la porte ET commune (55), transmettant un signal de données de repérage (B) correspondant à chaque signal de données caractéristique (61) à sa sortie (58) lorsque le signal de déclenchement (A) décroît.

8. Constitution de circuit suivant la revendication 6,
**caractérisé en ce que,**
- le circuit de sélection (25) comporte côté entrée trois comparateurs (44, 45, 46) alimentés en parallèle par les signaux de données, dont le premier (44) est réglé sur un seuil défini, inférieur au seuil zéro, le deuxième comparateur (45) sur le seuil zéro et le troisième comparateur (46) sur un seuil défini, supérieur au seuil zéro des signaux de données (D),
- un troisième temporisateur (65) est subordonné au troisième comparateur (46) et une minuterie (64) au deuxième comparateur (45),
- l'intervalle de temps (T3) réglé sur le troisième temporisateur (65) étant plus petit que la durée d'un signal de données et l'intervalle de temps (Tz) réglé sur la minuterie (64) étant plus petit que l'intervalle de temps (T3) du troisième temporisateur (65), mais plus long que le temps de descente maximum possible d'un signal de données,
- une porte ET (63) commune au troisième temporisateur (65) et à la minuterie (64). ainsi qu'au premier comparateur (44) leur est subordonnée pour créer un signal de déclenchement (A') et
- un temporisateur supplémentaire (57) est subordonné à la porte ET commune (63). transmettant un signal de données de repérage (B') correspondant à chaque signal de données caractéristique (61) à sa sortie (58) lorsque le signal de déclenchement (A') décroît.

9. Constitution de circuit suivant la revendication 7,
**caractérisé en ce que,**
- un troisième temporisateur (65) est connecté à la sortie du troisième comparateur (46) et une minuterie supplémentaire (64) est connectée à la sortie du deuxième comparateur (45)
- l'intervalle de temps (T3) réglé sur le troisième temporisateur (65) étant plus petit que la durée d'un signal de données et l'intervalle de temps (Tz) réglé sur la minuterie (64) étant plus petit que l'intervalle de temps (T3) du troisième temporisateur (65), mais plus long que le temps de descente maximum possible d'un signal de données,
- une porte ET (63) commune au troisième temporisateur (65) et à la minuterie (64), ainsi qu'au premier comparateur (44) leur est subordonnée pour créer un signal de déclenchement (A') et
- le temporisateur supplémentaire (57) est subordonné à la deuxième porte ET commune (63), celui-ci transmettant aussi un signal de données de repérage (B') correspondant à chaque signal de données caractéristique à sa sortie (58) lorsque le signal de déclenchement (A') envoyé par la deuxième porte ET commune (63) décroît.
